(19) **Europäisches Patentamt**

**European Patent Office**

**Office européen des brevets**

(11) **EP 1 542 282 A1**

(12) **EUROPEAN PATENT APPLICATION**

(43) Date of publication:
**15.06.2005 Bulletin 2005/24**

(51) Int Cl.⁷: **H01L 23/528**, G06F 1/32

(21) Application number: **04029114.8**

(22) Date of filing: **08.12.2004**

(84) Designated Contracting States:
**AT BE BG CH CY CZ DE DK EE ES FI FR GB GR HU IE IS IT LI LT LU MC NL PL PT RO SE SI SK TR**
Designated Extension States:
**AL BA HR LV MK YU**

(30) Priority: **08.12.2003 KR 2003088598**

(71) Applicant: **Samsung Electronics Co., Ltd.**
**Suwon-si, Gyeonggi-do (KR)**

(72) Inventors:
• **Lee, Jong-Rim**
**Yeongtong-gu Suwon-si Gyeonggi-do (KR)**
• **Im, June-Hyeok**
**Yeongtong-gu Suwon-si Gyeonggi-do (KR)**
• **Kim, Dong-Yun**
**Yeongtong-gu Suwon-si Gyeonggi-do (KR)**

(74) Representative: **Lang, Johannes, Dipl.-Ing. et al**
**Bardehle Pagenberg Dost**
**Altenburg Geissler Isenbruck**
**Postfach 86 06 20**
**81633 München (DE)**

(54) **Low-power semiconductor chip with separated power ring, method for manufacturing the same, and method for controlling the same**

(57) Disclosed is a semiconductor chip comprising power pads for receiving power, a plurality of pad groups grouped according to functions in such a manner that each pad group includes at least one input/output pad, separated power rings connected to each of pad groups and for delivering power supplied from the power pads to each of the pad groups, and a switch control unit for determining usage states for input/output pads of the pad groups and for performing on/off control with respect to each of the pad groups. The pad group comprises at least simultaneously-operating input/output pad, and is grouped in such a manner that the pad group includes at least two pads sharing power supplied from one power pad. A switch control unit determines a usage state for each of the pad groups and, as a result of the determination, turns off input/output pads of an idle pad group.

FIG.2

**Description**

**BACKGROUND OF THE INVENTION**

Field of the Invention

The present invention relates to a semiconductor chip, and more particularly to a semiconductor chip requiring a low power design.

Description of the Related Art

In application specific integrated circuits (ASICs), particularly, digital semiconductor circuits used for mobile or wireless appliances, a low power design is important. This is because the mobile and wireless appliances use power for charging due to their characteristics, and power dissipation of a charging battery must be minimized so that the appliances may use the power for charging over a long duration.

In a design of the digital semiconductor circuits, a total amount of power dissipation may be represented as a summation of an amount ($P_{AC}$) of power dissipation in an operation state and an amount ($P_{DC}$) of power dissipation in a waiting state. Herein, the amount of power dissipation in the waiting state has been regarded as a negligible amount as compared with the amount of power dissipation in the operating state. However, recently, as the scale of an integrated circuit (IC) chip, the number of gates included in a semiconductor chip, and the number of input/output pads (I/O PADs) increase, the relative importance of static current causing the power dissipation in the waiting state has increased.

In the meantime, ASICs employ power pads in order to receive power. The power pads are units for supplying power to cores in a semiconductor chip together with the signal input/output pads. Generally, the power pads are classified into analog power pads and digital power pads, which are designed in such a manner that the analog power pads and the digital power pads supply analog power and digital power, respectively.

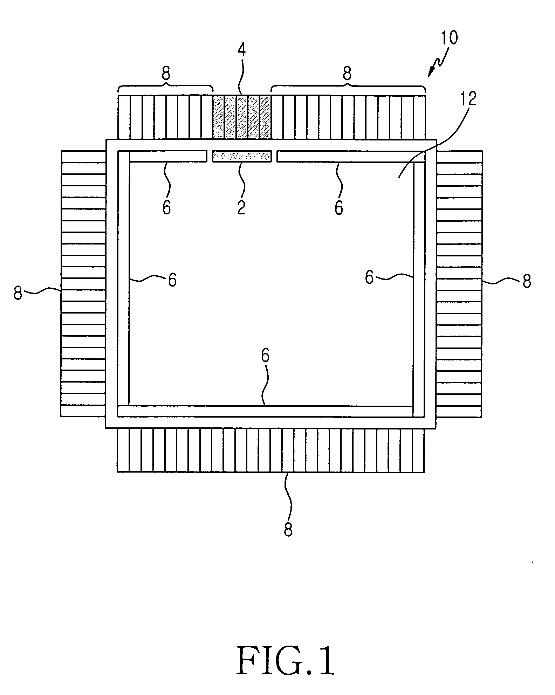

FIG. 1 illustrates a structure of a typical semiconductor chip 10.

The semiconductor chip 10 is mounted on a semiconductor chip paddle positioned on a lead frame and interfaces with external circuits through the lead frame. The semiconductor chip 10 has pads 4 and 8 formed at peripheral portions of the semiconductor chip 10, which are used for power, grounding, and signal exchange with external circuits. Also, the semiconductor chip 10 includes power rings 2 and 6 formed at the inner side of the semiconductor chip 10, which delivery power (generally, marked as 'VDD') received through power pads from among the pads 4 and 8 to semiconductor circuits through internal wiring.

The power rings 2 and 6 are classified into an analog part and a digital part, respectively, in which the analog part receives power from an analog power pad 4 in order to supply power to analog circuits in the inside of the semiconductor chip, and the digital part is connected to a digital power pad 8 in order to supply power to digital circuits in the inside of the semiconductor chip 10.

Generally, the analog power pad 4 can turn on/off power according to a usage state of the analog power pad 4. However, the digital power pad 8 always turns on power regardless of the functions and the operating state of the digital power pad 8. Accordingly, a continuous power-on state of the digital power pad is a main cause of static current consumption in a waiting state.

SUMMARY OF THE INVENTION

Accordingly, the present invention has been made to solve the above-mentioned problems occurring in the prior art, and an object of the present invention is to provide a semiconductor chip, a method for manufacturing the same, and a method for controlling the same, which can reduce power dissipation in bi-directional pads and output pads of the semiconductor chip in a waiting state.

Another object of the present invention is to provide a semiconductor chip, a method for manufacturing the same, and a method for controlling the same, which can turn power supplied through pads on and off according to a usage state of a corresponding pad function in a semiconductor circuit.

Still another object of the present invention is to provide a semiconductor chip, a method for manufacturing the same, and a method for controlling the same, which can classify power rings for supplying power to circuits inside the semiconductor chip according to functions of the power rings.

In order to accomplish these objects, there is provided a semiconductor chip comprising power pads for receiving power from an external device, a plurality of pad groups grouped according to functions in such a manner that each pad group includes at least one input/output pad, separated power rings connected to each of the pad groups and for delivering power supplied from the power pads to each of the pad groups, and a switch control unit for determining the usage states for the input/output pads of the pad groups and for performing on/off switching control with respect to each of the pad groups.

According to another aspect of the present invention, there is provided a method for manufacturing a semiconductor chip including pads supplying power and inputting/outputting a signal, the method comprising the steps of grouping input/output pads into a plurality of pad groups, each pad group including at least one simultaneously-operating pad, and connecting each separated ring to each pad group such that an on/off state of each pad group is controlled.

According to another aspect of the present invention, there is provided a method for controlling a semiconductor chip including power pads receiving power from an external device, a plurality of pad groups grouped according to functions, and separated power rings, each power ring delivering the power supplied from the power pads to each pad group, the method comprising the steps of determining a usage state of each pad group and turning off the input/output pads of an idle pad group.

BRIEF DESCRIPTION OF THE DRAWINGS

The above and other objects, features and advantages of the present invention will be more apparent from the following detailed description taken in conjunction with the accompanying drawings, in which:

FIG. 1 illustrates a structure of a typical semiconductor chip;

FIG.S. 2 and 3 illustrate a sectional view and a structure of a lead frame of a semiconductor package according to an embodiment of the present invention; and

FIG. 4 illustrates a structure of a semiconductor chip having separated power pads according to an embodiment of the present invention.

DETAILED DESCRIPTION OF THE PREFERRED EMBODIMENTS

Hereinafter, preferred embodiments of the present invention will be described in detail with reference to the accompanying drawings. Note that the same or similar components in the drawings are designated by the same reference numerals as far as possible although they are shown in different drawings. In the following description of the embodiments of the present invention, a detailed description of known functions and configurations incorporated herein will be omitted for the sake of clarity.

In the following description of the embodiments of the present invention, an application specific integrated circuit (ASIC), particularly, a semiconductor chip requiring low power is designed in such a manner that static power loss in the input/output pads is reduced by switching power of the input/output pads on and off according to environmental conditions. In detail, according to embodiments of the present invention, if a specific function is not carried out, power to the input/output pads having the specific function is cut off.

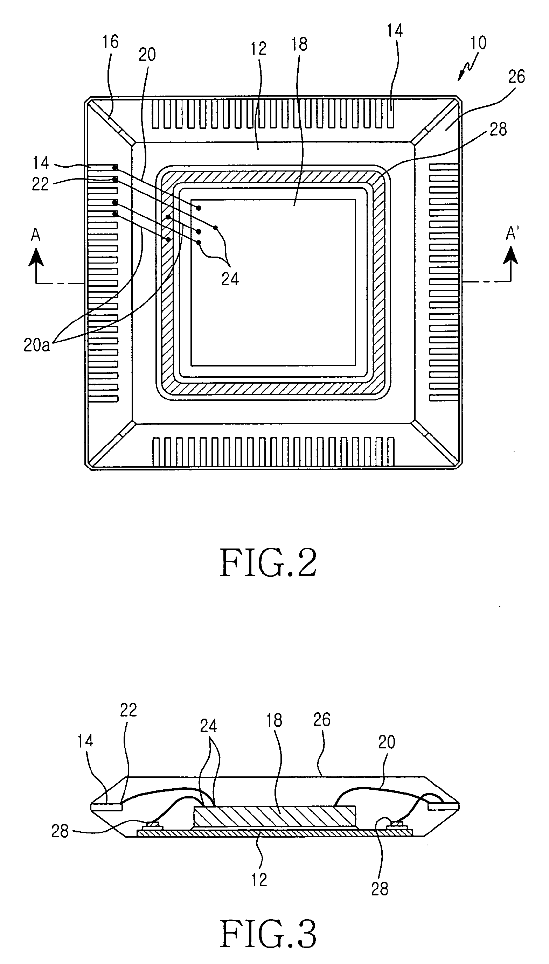

FIGS. 2 and 3 illustrate a sectional view and a structure of a lead frame of a semiconductor package according to a preferred embodiment of the present invention.

A plurality of leads 14 are arranged along two opposite sides or four sides of a lead frame 26 made from copper or an alloy of copper. A semiconductor chip paddle 12 for mounting a semiconductor chip 18 is surrounded by the leads 14 and is disposed at the same level or at a level slightly lower than that of the leads 14. The semiconductor chip paddle 12 is supported by tier bars 16 extending from four corners of the lead frame 26. Also, input/output (I/O) power pads 24 on the semiconductor chip 18 are connected to bond fingers 22 of the leads 14 by means of wire 20 through a bonding scheme in order to electrically connect the semiconductor chip 18 to the leads 14.

The semiconductor chip paddle 12 has a rectangular power metal plate 28 formed on an upper surface of the semiconductor chip paddle 12. The power metal plate 28 is disposed at a predetermined space on the upper surface of the semiconductor chip paddle 12 between the central portion on which the semiconductor chip 18 is mounted and the inner ends of the leads 14.

Power is supplied to the power metal plate 28 from a predetermined number of leads used for supplying power among the leads 14 through wire 20a. The supplied power is transferred to the pads 24 of the inside of the semiconductor chip 18 through the wire 20a. The pads 24 deliver the power to circuits included in the semiconductor chip 18 by means of power rings 2 or 6 inside of the semiconductor chip 18.

One semiconductor chip is designed with integrated circuits (ICs) performing various functions and interfaces with external devices through the I/O pads. According to embodiments of the present invention, in order to divide plural pads provided on one semiconductor chip into several groups having pads operating simultaneously, each pad group is connected to each separated power ring. The grouping of pads is performed according to the pads that perform the same function. In detail, the grouping is performed according to pads receiving power through at least one power lead.

Each pad group can individually be in an on or off state under the control of the semiconductor chip. Accordingly, when the pads connected to one power ring are not used, power can be saved by turning off the pads. If power of several pad groups is controlled by repeating the above-described operation, overall power dissipation of the I/O pads may be reduced in a waiting state.

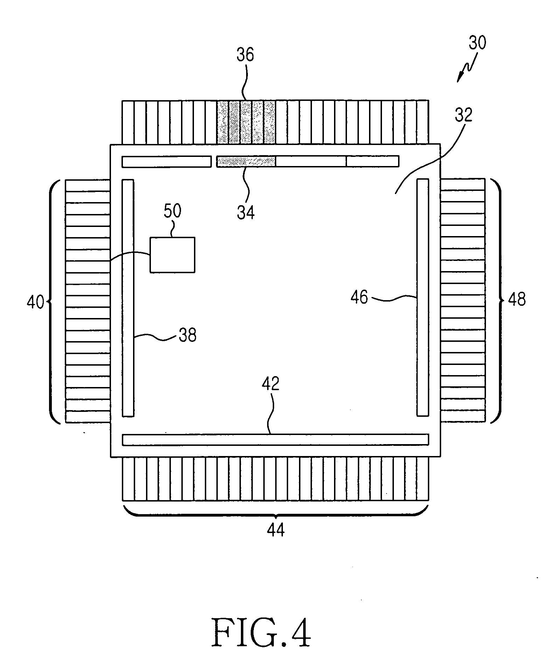

FIG. 4 illustrates a structure of a semiconductor chip having separated power pads according to an embodiment of the present invention.

The semiconductor chip 30 is mounted on the semiconductor chip paddle of the lead frame and interfaces with external devices through the lead frame. The semiconductor chip 30 has pads formed at peripheral portions of the semiconductor chip 30, which are used for power, grounding, and signal exchange with external circuits. Herein, reference numerals 36, 40, 44, and 48 represent groups of pads capable of operating individually according to various functions from among the input/output pads.

The pad groups 36, 40, 44, and 48 are grouped according to separated power rings 34, 38, 42, and 46 delivering power (generally, marked as 'Vdd') supplied through power pads. The power rings 34, 38, 42, and 46 are classified into either analog or digital power rings. An analog power ring 34, which is connected to the analog pad group 36 in order to supply analog power received from an analog power pad to the analog pad group 36 from among the pad groups 36, 40, 44, and 48, and digital power rings, which are connected to the digital pad groups 40, 44, and 48, respectively, in order to supply digital power received ($V_{DD}$) from a digital power pad to the digital power pad groups 40, 44, and 48 from among the pad groups 36, 40, 44, and 48. The digital power rings 38, 42, and 46 are divided in order to be connected to corresponding pad groups 40, 44, and 48, which can operate individually, respectively.

Typically, a semiconductor chip always receives power in an operation state and a waiting state when the semiconductor chip is enabled. That is, power received from a power pad is always applied to a power ring. The pad groups 36, 40, 44, and 48 can be individually turned on and off under the control of a switch control unit 50 in the semiconductor chip. When a pad group with a specific function is used, the switch control unit 50 turns on that pad group. When the pad group is not used, the switch control unit 50 turns off that pad group. Herein, turning on the pad group means that the input and output pads of the pad group are connected to a power ring, and turning off the pad group means that the pad group is disconnected from the power ring. Therefore, when the pad group is turned off, the pad group does not operate, so that power is not consumed when in a waiting state.

In detail, pads of a pad group receiving power from one separated power ring may be input or output pads having access to a memory device through a bus. When a memory access is performed, the switch control unit 50 turns on the pad group, and when a memory access is not performed, the switch control unit 50 turns off the pad group.

Hereinafter, a method for manufacturing a semiconductor chip will be described according to an embodiment of the present invention.

First, the digital input/output pads of the semiconductor chip are divided into a plurality of pad groups according to the function of each pad. One pad group includes at least one pad for receiving power through at least one power pad. Also, as many separated power rings as there are pad groups may be arranged on the semiconductor chip. The power rings are preferably made from metal in order to deliver power supplied from the power pad to the input/output pads. The pad groups preferably are coupled with the power rings through internal wiring.

Hereinafter, a control operation of the separated power rings according to an embodiment of the present invention will be described.

The switch control unit positioned on the semiconductor chip determines the usage state of each pad group periodically or whenever a determination for the usage sate is required. If the switch control unit determines that power must be supplied to a corresponding pad group, the switch control unit turns on the in-put/output pads of the corresponding pad group. Otherwise, the switch control unit repeatedly performs the operation of turning off input/output pads of a corresponding pad group with respect to all pad groups.

In a control operation according to another embodiment of the present invention, the switch control unit maintains the off-states with respect to all of the input/output pads of the pad groups. When usage of a pad group corresponding to a specific function is required, the switch control unit turns on the input/output pads of the pad group. If usage of the pad group in a power-on state is stopped, the switch control unit turns off the input/output pads of the corresponding pad group.

As described above, the total amount of power dissipation may be represented as summation of an amount ($P_{AC}$) of power dissipation in an operation state and an amount ($P_{DC}$) of power dissipation in a waiting state in a design of a digital semiconductor.

A total amount of static power dissipation in a CMOS circuit is calculated by using summation of an amount of leakage current and an amount of in-put/output current. Herein, the leakage current is generated between a well and a substrate in a reverse bias state. Generally, since there is no ground DC power passing through the CMOS circuit in a waiting state, only leakage current exists in a static state in the inside of the CMOS circuit. The leakage current is a negligible quantity of a few □. However, if the number of gates of the CMOS circuit increases, the leakage current may be one of the important factors causing power dissipation .

Also, the input/output current passing through an input/output buffer is generated when the CMOS circuit interfaces with another elements such as a TTL, etc. Herein, although the full up/ full down transistor current of the input buffer is a negligible quantity of several tens of □, the current of the output buffer or a bi-directional buffer causes a problem. Accordingly, an amount of DC current consumption in the output buffer may become a large amount of the total static current consumption. DC power dissipation through output buffering and the bi-directional buffering can be calculated in Equation 1.

[Equation 1]

$$P_{DC\_OUT}[mW] = (\sum_{k=1}^{n}(V_{OL(k)} \times I_{OL(k)} \times t_{L(k)}) + \sum_{k=1}^{n}((V_{DD} - V_{OH(k)}) \times I_{OH(k)} \times t_{H(k)})/T$$

$$P_{DC\_BI}[mW] = (\sum_{k=1}^{n}(V_{OL(k)} \times I_{OL(k)} \times t_{L(k)}) + \sum_{k=1}^{n}((V_{DD} - V_{OH(k)}) \times I_{OH(k)} \times t_{H(k)}) \times S_{out}/T$$

Herein, $P_{DC\_OUT}$ denotes an amount of DC power dissipation through the output buffering, and $P_{DC\_BI}$ denotes an amount of DC power dissipation through the bi-directional buffering. $V_{OL}$, $I_{OL}$, $V_{OH}$, and $I_{OH}$ denote the voltage and current in a low state and a high state, respectively, and $V_{DD}$ denotes the voltage of digital supply power. Also, n denotes the number of output buffers or bi-directional buffers, T denotes the total operation time in an output mode, $t_H$ denotes a summation amount of total time in a high state, and $t_L$ denotes a summation amount of the total time in a high state. Accordingly, on the assumption that the output buffers and the bi-directional buffers are not in a tri-state, a value of T is the value of $t_H + t_L$. $S_{out}$ denotes an output mode rate of the bi-directional buffers and the value of $S_{out}$ is approximately 0.5.

Also, DC static current can be represented by means of Equation 1.

For example, if the input/output pads connected to the output buffers or the bi-directional buffers are divided into three digital power groups according to each of the groups functions, and if only first and second groups operate among other things, the amount of static current consumption for a third group is '0'. That is, a power ring corresponding to the third group has been turned off. When output and bi-directional pads are controlled in the above-described manner, it can be expected for static current to be reduced in proportion to the number of turned-off pads. Specifically, if simultaneously-operating pads occupy 50 % of total pads, the amount of static current is reduced to 50 %.

Hereinafter, the effects of the embodiments of the present invention, especially the effects of the above-described embodiments of the present invention, will be briefly described.

As described above, individually existing pads or pads grouped according to each pad's functions are each connected to one of the separated power rings, and the on/off states of the power rings are controlled according to the operation states of each pad or pad group, thereby reducing DC current consumption in the waiting state of a semiconductor chip.

While the invention has been shown and described with reference to certain preferred embodiments thereof, it will be understood by those skilled in the art that various changes in form and details may be made therein without departing from the spirit and scope of the invention. Consequently, the scope of the invention should not be limited to the embodiments, but should be defined by the appended claims and equivalents thereof.

**Claims**

1. A semiconductor chip comprising:

> power pads for receiving power from an external device;
> a plurality of pad groups grouped according to the pad groups' functions in such a manner that each pad group includes at least one input/output pad;
> separated power rings connected to each of the pad groups for delivering power supplied from the power pads to each of the pad groups; and
> a switch control unit for determining usage states for input/output pads of the pad groups and for performing on/off control with respect to each of the pad groups.

2. The semiconductor chip as claimed in claim 1, wherein the switch control unit determines a usage state for each of the pad groups and disconnects the input/output pads of an idle pad group from a corresponding power ring.

3. The semiconductor chip as claimed in claim 1, wherein each pad group includes at least one simultaneously-operating input/output pad.

4. A method for manufacturing a semiconductor chip including pads supplying power and inputting/outputting a signal, the method comprising the steps of:

   grouping input/output pads into a plurality of pad groups, each pad group including at least one simultaneously-operating pad; and
   connecting each separated ring to each pad group such that an on/off state of each pad group is controlled.

5. The method as claimed in claim 4, wherein, in the step of grouping the input/output pads, the grouping is performed in such a manner that each pad group includes at least pads sharing power supplied through one power pad.

6. A method for controlling a semiconductor chip including power pads receiving power from an external device, a plurality of pad groups grouped according to the pad groups' functions, and separated power rings, each power ring delivering the power supplied from the power pads to each pad group, the method comprising the steps of:

   determining a usage state of each pad group; and
   turning off input/output pads of an idle pad group.

7. The method as claimed in claim 6, wherein, in the step of turning off the input/output pads, the input/output pads of the pad group are disconnected from a corresponding power ring.

8. The method as claimed in claim 6, further comprising a step of turning on the input/output pads of a used pad group as a result of the determination of the pad group usage state.

FIG.1

FIG.2

FIG.3

EP 1 542 282 A1

FIG.4

**European Patent Office**

## EUROPEAN SEARCH REPORT

Application Number

EP 04 02 9114

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| Y | US 6 195 755 B1 (WEBSTER LARRY D ET AL) 27 February 2001 (2001-02-27) * claim 1 * | 1-8 | H01L23/528 G06F1/32 |
| Y | US 2003/067048 A1 (LIN WEI-FENG ET AL) 10 April 2003 (2003-04-10) * figures 1,2A,2B * | 1-8 | |
| A | PATENT ABSTRACTS OF JAPAN vol. 2003, no. 11, 5 November 2003 (2003-11-05) & JP 2003 202935 A (MITSUBISHI ELECTRIC CORP), 18 July 2003 (2003-07-18) * the whole document * | 1-8 | |
| A | US 2002/104031 A1 (TOMLINSON JOCK F ET AL) 1 August 2002 (2002-08-01) * the whole document * | 1-8 | |

TECHNICAL FIELDS SEARCHED (Int.Cl.7)

H01L
G06F

The present search report has been drawn up for all claims

| Place of search | Date of completion of the search | Examiner |
|---|---|---|
| Munich | 22 March 2005 | Cortes Rosa, Joao |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 04 02 9114

This annex lists the patent family members relating to the patent documents cited in the above-mentioned European search report.
The members are as contained in the European Patent Office EDP file on
The European Patent Office is in no way liable for these particulars which are merely given for the purpose of information.

22-03-2005

| Patent document cited in search report | | Publication date | Patent family member(s) | Publication date |
|---|---|---|---|---|
| US 6195755 | B1 | 27-02-2001 | NONE | |
| US 2003067048 | A1 | 10-04-2003 | TW 571603 B | 11-01-2004 |
| JP 2003202935 | A | 18-07-2003 | NONE | |
| US 2002104031 | A1 | 01-08-2002 | NONE | |

EPO FORM P0459

For more details about this annex : see Official Journal of the European Patent Office, No. 12/82